# DEMANDE DE BREVET EUROPEEN

(11) **EP 1 035 573 A1**
(43) Date de publication de la demande: **13.09.2000**
(21) Numéro de dépôt: 00400630.0
(22) Date de dépôt: 08.03.2000
(51) Int. Cl.: H01L 21/60

(54) **Composant électrique de puissance à montage par brasage sur un support et procédé de montage correspondant**

(30) Priorité: 09.03.1999 FR 9902878
(71) Demandeur: SAGEM S.A., 75116 Paris (FR)
(72) Inventeur: Pradel, Denis, 95480 Pierrelaye (FR)
(74) Mandataire: Bloch, Gérard

(57) **Abrégé**

Le composant électrique de puissance est pourvu d'électrodes (4, 5, 24, 25) dont, sur une (3, 23) des faces (2, 3; 22, 23) du composant (1, 21), une électrode unique (5, 25), les électrodes (4, 5; 24, 25) pouvant être reliées par brasage à un support de raccordement électrique (10, 30), et l'électrode unique (5, 25) pouvant être reliée au support (10, 30) par l'intermédiaire d'une plaque (9, 29) de liaison électrique et thermique.

## Description

La présente invention concerne les composants électriques de puissance, tels que transistors, que l'on monte sur une carte de circuit imprimé ou équivalent. Ils trouvent par exemple une application dans le domaine automobile pour le contrôle moteur ou encore pour réaliser des convertisseurs de puissance.

Le montage, sur un même circuit imprimé, d'un composant de puissance et de composants électriques autres qui doivent y être reliés vise à faciliter la tâche d'établissement des connexions correspondantes.

Cette tâche nécessite cependant plusieurs opérations, car un composant de puissance comporte deux faces actives, l'une à électrode unique telle que collecteur de transistor ou électrode de diode et l'autre face comportant l'autre électrode de diode ou les autres électrodes du transistor.

Pour raccorder électriquement les électrodes de ces deux faces aux autres composants, les pistes du circuit imprimé ne permettent de relier directement que la ou les électrodes de l'une des faces, plaquée sur le circuit imprimé. De plus, comme il s'agit d'un composant de puissance, il est traversé par des courants élevés, ce qui nécessite des liaisons de raccordement de forte section. En outre, il faut pouvoir dissiper la chaleur engendrée par ce composant de puissance.

La présente invention vise à faciliter le montage d'un tel composant électrique de puissance sur un support de liaison électrique.

A cet effet, l'invention concerne tout d'abord un composant électrique de puissance pourvu d'électrodes dont, sur une des faces du composant, une électrode unique, les électrodes étant agencées pour être reliées par brasage à un support de raccordement électrique, ladite électrode unique étant agencée pour être reliée au support par l'intermédiaire d'une plaque de liaison électrique et thermique.

Ainsi, par une seule opération de brasage, on peut relier électriquement les électrodes des deux faces du composant au support, tout en assurant une fixation mécanique du composant à ce support, de même que de faibles résistances électrique et thermique par rapport à celui-ci, grâce au fait qu'une plaque présente une section bien plus grande qu'un simple fil.

On connaissait certes des composants, mais de faible puissance, à une seule face active, à braser sur un circuit imprimé pour les y fixer par un face inactive, de dessous, opposée à la face active, de dessus, et pour ensuite raccorder électriquement les électrodes de la face active au circuit imprimé par des fils soudés un par un.

Une autre solution connue, pour relier de tels composants de faible puissance au circuit imprimé, consiste à réaliser des protubérances de brasage sur les électrodes de la face active et à plaquer celle-ci sur le circuit pour l'y relier ainsi mécaniquement et électriquement.

Ces deux arts antérieurs, à face active unique, ne permettaient pas d'aboutir à la solution de l'invention.

L'invention concerne aussi une carte de composants électriques dont un composant de puissance de l'invention, avec des plages d'accueil reliées par brasage aux électrodes du composant de puissance, à ladite électrode unique par l'intermédiaire d'une plaque de liaison électrique et thermique.

L'invention concerne enfin un procédé de montage sur un support de raccordement électrique, d'un composant électrique de puissance pourvu d'électrodes dont, sur une des faces du composant, une électrode unique, procédé caractérisé par le fait qu'on met en place le composant sur le support et qu'on place les électrodes en regard de plages de brasage du support reliées à des pistes conductrices, on pose au moins une plaque sur la face à électrode unique du composant, en interposant une couche de produit à braser, et on effectue un passage de la carte dans un four de brasage pour relier collectivement toutes ses électrodes aux plages d'accueil et transformer la plaque en plaque de liaison électrique et thermique.

L'établissement de toutes les connexions s'effectue ainsi de façon globale en une seule étape.

L'invention sera mieux comprise à l'aide de la description suivante de deux formes de réalisation préférées du composant électrique de puissance de l'invention et d'un mode préféré de montage de celui-ci sur une carte, en référence au dessin annexé, sur lequel :
- la figure 1 est une vue en section latérale représentant le composant monté sur une carte de circuit imprimé, et
- la figure 2 est une autre vue en section latérale du composant, monté dans une fenêtre de circuit imprimé.

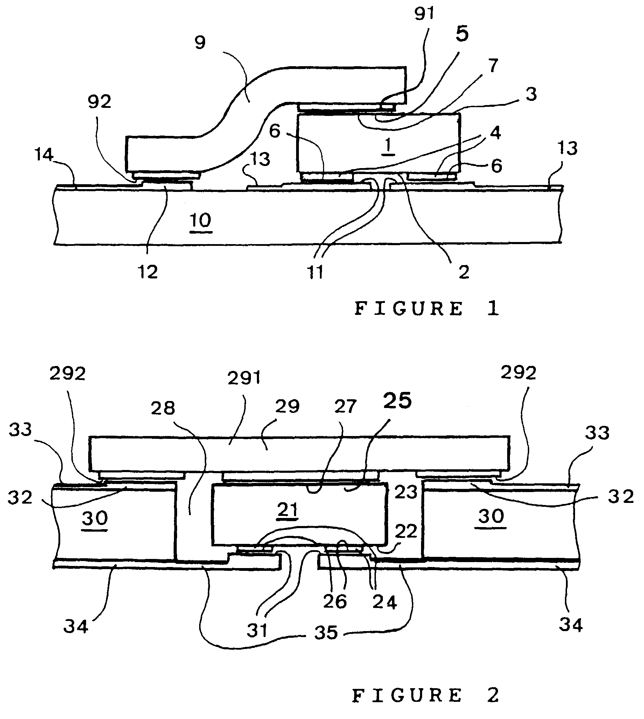

Sur la figure 1, le composant électrique de puissance représenté est une puce 1 de matériau semi-conducteur fixée sur une carte 10 de circuit imprimé dont une seule face porte des pistes 13, 14 en cuivre étamé, de 400 pm d'épaisseur dans cet exemple. Les pistes 13, 14 permettent de relier électriquement les électrodes, ci-après définies, de la puce 1 à d'autres circuits électriques portés par la carte 10.

La puce 1, de forme sensiblement parallélépipédique rectangle, comporte deux faces actives 2, 3, ici opposées et horizontales et perpendiculaires au plan de la figure 1. La face 3, supérieure sur la figure 1, comporte une électrode unique 5, qui correspond par exemple au drain ou au collecteur dans le cas d'un transistor, ou à l'une des deux électrodes d'une diode. La fonction de la puce de puissance 1 n'est cependant pas limitée à ces types de fonctions. La face inférieure 2 comporte une autre ou d'autres électrodes, ici deux électrodes globalement référencées 4, telles qu'émetteur et base de transistor, nécessaires au fonctionnement de la puce 1 en relation avec d'autres composants.

Toutes ces électrodes 4, 5 ont été produites par dépôt d'une couche de métallisation lors de la fabrication de plaquettes de semi-conducteur comportant des puces, non encore découpées, telles que celle référencée 1. Chaque électrode 4, 5 porte en surface, dans cet exemple, une couche d'un produit permettant le brasage, formant une plage de contact de raccordement externe 6, respectivement 7. Les électrodes 4 comportent des protubérances, recouvertes du produit de brasage, comme entretoises entre la face 2, de montage, du composant 1 et la carte support 10 de raccordement électrique.

Les pistes 13 du circuit imprimé 10 se poursuivent chacune en une plage 11 d'accueil d'une plage 6 du composant, et portant un produit pour le brasage, l'ensemble des plages de brasage 11 du circuit imprimé support 10 formant un motif correspondant à la disposition des plages 6, afin de les recevoir.

En outre, le circuit imprimé 10 porte une plage d'accueil 12, aussi de brasage, de grande surface, au sens électrique et/ou thermique, reliée à la piste 14, sur laquelle peut être brasée une zone 92 de plage de contact à braser, ici d'extrémité, d'une plaque 9, de connexion électrique et thermique, dont une autre zone 91 de plage de contact à braser, ici d'extrémité opposée, peut être brasée sur la plage 7 de l'électrode unique 5 de la face supérieure 3, de raccordement. Les deux plages de contact 91, 92 s'étendent dans deux plans horizontaux sur la figure 1, donc parallèles au plan de la carte 10 et aux faces 2 et 3. La plaque 9 constitue un barreau présentant des plages 91, 92 de grande surface, horizontale sur la figure 1, pour établir des contacts par brasage avec la plage 7 et la plage d'accueil 12.

La plaque 9, par exemple à base de cuivre, assure une liaison à faibles résistances électrique et thermique entre la puce 1 et le circuit imprimé 10. Les calories dissipées par la puce 1 peuvent ainsi être évacuées à l'extérieur de celle-ci vers tout puits thermique, la plaque 9 elle-même rayonnant une partie de l'énergie thermique qu'elle reçoit et constituant donc un radiateur. La plaque 9 peut être unique comme représenté ou bien elle peut être divisée en une pluralité de telles plaques, électriquement et thermiquement en parallèle, pour, par exemple, pallier des difficultés de jeu et de tolérance.

Pour le montage sur la carte 10 de la puce 1 pourvue des électrodes 4, 5, dont l'électrode unique 5 sur la face de raccordement 3 de la puce 1 et au moins une électrode comme celle référencée 4, ici plusieurs, sur la face de montage 2 de la puce 1, on met en place la puce 1 sur la carte 10 et on place l'électrode 4 de la face de montage 2 en regard de la plage de brasage 11 de la carte 10 reliée à la piste conductrice 13, on pose la plaque 9 ou une pluralité de telles plaques sur la face de raccordement 3 à électrode unique 5 de la puce 1 et sur l'autre plage de brasage 12 de la carte 10 reliée à la piste conductrice 14 en interposant une couche de produit à braser, et on effectue un passage de la carte 10 dans un four de brasage pour relier collectivement toutes ses électrodes 4, 5 aux plages d'accueil 11, 12 et transformer la plaque 9 en plaque de liaison électrique et thermique.

La réalisation de la figure 2 correspond très schématiquement à celle de la figure 1 dans laquelle on aurait écrasé la plaque 9 jusqu'au niveau du circuit imprimé 10 et ainsi translaté d'autant vers le bas, à travers le circuit imprimé 10, la puce 1 et les plages d'accueil 11, qui seraient alors au niveau de la face inférieure du circuit 10.

Dans la réalisation de la figure 2, la puce, alors référencée 21, est cette fois logée dans l'épaisseur de la carte de circuit imprimé 30 double face. Dans cet exemple, la puce 21 a sensiblement l'épaisseur de la carte de circuit imprimé 30, si bien que son logement 28, ici fraisé dans le verre époxy séparant les deux faces, débouche sur les deux faces opposées du circuit imprimé 30. La face supérieure de ce dernier porte des pistes 33, reliées à des plages d'accueil à braser 32 et sa face inférieure porte un motif de plages d'accueil à braser 31 reliées chacune à une piste 34 particulière et portées chacune par une languette conductrice 35 constituant un prolongement d'une piste 34. On notera que le logement 28 pourrait être ménagé différemment par exemple par emboutissage de l'isolant avant dépôt des couches conductrices.

La puce 21 a la même structure que la puce 1, avec une face inférieure 22 à électrodes 24 avec plages de contact à braser 26 et une face supérieure 23 à électrode unique 25 avec plage de contact à braser 27. Le procédé de montage sur sa carte support 30 est le même que celui indiqué pour la puce 1. Une carte support pourrait en particulier porter un ou plusieurs composants 1 selon le montage indiqué en figure 1 et un ou plusieurs composants 21 montés selon la figure 2, pour les relier entre eux.

La plaque 9 est ici remplacée par une plaque 29 entièrement plane plaquée sur le circuit imprimé 30 au-dessus du logement 28 et en débordant latéralement pour se raccorder par brasage de plage(s) 292 à une des plages d'accueil 32, homologue de la plage d'accueil 12, et de préférence comme ici à une plage d'accueil 32 située en périphérie du logement 28. On améliore ainsi la rigidité mécanique et diminue les résistances électrique et thermique de liaison entre la puce 21 et la carte 30. C'est la plaque 29 qui assure la solidarisation de la puce 21 avec la carte 30.

Comme indiqué, les plages d'accueil 31 sont disposées sur des languettes 35 respectives en porte-à-faux sur la couche de verre époxy ou autre constituant l'âme isolante de la carte 30, c'est-à-dire que les languettes 35 font saillie depuis la paroi du logement 28. De ce fait, elles constituent des poutres ou doigts flexibles qui absorbent les contraintes mécaniques éventuelles dues à des dilatations thermiques différentes entre la puce 21 et la carte 30, en particulier lors du brasage et des cycles thermiques ultérieurs.

En variante, la plaque 29 pourrait être remplacée par une couche conductrice imprimée sur la face supérieure du circuit imprimé 30, formant alors le fond du logement 28, d'épaisseur suffisante pour assurer la tenue mécanique et la liaison électrique de la puce 21. En pareil cas, la puce 21 serait introduite dans son logement en écartant les languettes flexibles 35 qui gênent partiellement son accès.

La fabrication des puces 1, 21 s'effectue de façon classique à partir de minces plaquettes de matériau semi-conducteur, sur lesquelles on a élaboré les différentes couches constitutives des composants électroniques utilisés, pour former une mosaïque de zones élémentaires qui, après découpage de la plaquette, forment les puces.

Ici, chaque zone comportant une face 3, 23 à électrode unique et une face opposée 2, 22, à au moins une électrode, on dépose, sur chaque face de la plaquette, une couche d'un produit d'accrochage à la plaquette puis, au-dessus, une couche d'un produit de brasage permettant de braser les deux faces 3, 23; 2, 22 de chaque puce 1, 21. Au besoin, on dépose sur la couche de produit d'accrochage, avant de déposer la couche du produit de brasage, une couche d'un produit d'adaptation du produit d'accrochage et du produit de brasage.

La couche d'accrochage, sur le semi-conducteur, tel que silicium, peut aussi servir de couche d'arrêt pour protéger le silicium de toute pénétration d'atomes provenant de la couche déposée sur la couche d'arrêt. Celle-ci est par exemple en titane/tungstène. La couche d'adaptation est par exemple en cuivre. C'est elle qui présente l'épaisseur la plus grande parmi les couches déposées, afin de produire une protubérance et ainsi assurer un contact avec les plages d'accueil comme 11 du circuit imprimé, la surface correspondante 2 de la puce 1 restant ainsi légèrement écartée de la surface du circuit imprimé 10 et protégée par une couche de passivation. La couche externe de produit de brasage est constituée par exemple par un dépôt d'un alliage étain/plomb qui assure la brasabilité voulue. Les plages d'accueil 11, 12, 31, 32 du circuit imprimé sont de même revêtues d'un produit semblable.

En variante, et selon le choix des machines d'assemblage employées, la pâte à braser peut être disposée sur l'une ou l'autre des surfaces à braser en regard.

## Revendications

1. Composant électrique de puissance pourvu d'électrodes (4, 5, 24, 25) dont, sur une (3, 23) des faces (2, 3; 22, 23) du composant (1, 21), une électrode unique (5, 25), les électrodes (4, 5; 24, 25) étant agencées pour être reliées par brasage à un support de raccordement électrique (10, 30), ladite électrode unique (5, 25) étant agencée pour être reliée au support (10, 30) par l'intermédiaire d'une plaque (9, 29) de liaison électrique et thermique.

2. Composant selon la revendication 1, dans lequel les électrodes (4, 5, 24, 25) comportent des protubérances, comme entretoises entre la surface (2, 22) du composant (1, 21) et le support (10, 30) de raccordement électrique.

3. Composant selon l'une des revendications 1 et 2, dans lequel la plaque (9, 29) est unique.

4. Carte de composants électriques dont un composant de puissance selon la revendication 1, avec des plages d'accueil (11, 12; 31, 32) reliées par brasage aux électrodes (4, 5; 24, 25) du composant de puissance (1, 21), à ladite électrode unique (5, 25) par l'intermédiaire d'une plaque (9, 29) de liaison électrique et thermique.

5. Carte selon la revendication 4, dans laquelle les plages d'accueil (11, 12) sont situées sur une même face de la carte (10) et la plaque (9) de liaison électrique et thermique présente deux zones (91, 92; 291, 292) brasées respectivement sur une des plages d'accueil (12, 32) et sur ladite électrode unique (5, 25).

6. Carte selon la revendication 4, dans laquelle la carte (30) comporte un logement (28) pour le composant de puissance (21) et des plages d'accueil (31, 32), sur deux faces, dont celle (32) d'une des faces pour recevoir la plaque (29) de liaison électrique et thermique.

7. Carte selon la revendication 6, dans laquelle la plaque (29) est entièrement plane.

8. Carte selon la revendication 7, dans laquelle le composant de puissance (21) a sensiblement l'épaisseur de la carte (30) et son logement (28) est limité par la plaque de liaison (29) et une pluralité de languettes flexibles (35) pourvues de plages d'accueil (31) et prolongeant des pistes conductrices (34) de la carte (30).

9. Procédé de montage, sur un support de raccordement électrique (10, 30), d'un composant électrique de puissance (1, 31) pourvu d'électrodes (4, 5; 24, 25), dont une unique (5, 25) sur une face de raccordement (3, 23) du composant (1, 31) et au moins une (4, 24) sur une face de montage (2, 32) du composant, procédé caractérisé par le fait qu'on met en place le composant (1, 31) sur le support (10, 30) et qu'on place l'électrode (4, 24) de la face de montage (2, 22) en regard d'une plage de brasage (11, 31) du support (10, 30) reliée à une piste conductrice (13, 33), on pose au moins une plaque (9, 29) sur la face de raccordement (3, 23) à électrode unique (5, 25) du composant (1, 31) et sur une autre plage de brasage du support (12, 32) reliée à une piste conductrice (14, 34), en interposant une couche de produit à braser, et on effectue un passage du support (10, 30) dans un four de brasage pour relier collectivement toutes ses électrodes (4, 5; 24, 25) aux plages d'accueil (11, 12; 31, 32) et transformer la plaque (9, 29) en plaque de liaison électrique et thermique.
